# EUROPEAN PATENT SPECIFICATION

(11) **EP 3 385 636 B1**
(45) Date of publication and mention of the grant of the patent: **14.06.2023**
(21) Application number: 17164529.4
(22) Date of filing: 03.04.2017
(51) Int. Cl.: F24F 13/32, F24F 11/30, H02G 3/10, H02G 3/08, H05K 5/00

(54) **WALL MOUNTABLE BACK PLATE FOR SECURING A BUILDING CONTROL MODULE TO A WALL**
WANDMONTIERBARE RÜCKPLATTE ZUR BEFESTIGUNG EINES GEBÄUDESTEUERUNGSMODULS AN EINER WAND
PLAQUE ARRIÈRE POUVANT ÊTRE MONTÉ SUR UN MUR POUR FIXER UN MODULE DE COMMANDE DE BÂTIMENT À UNE PAROI

(43) Date of publication of application: 10.10.2018
(73) Proprietor: Ademco Inc., Golden Valley, MN 55422 (US)
(72) Inventor: KYNOCH, David, Morris Plains, NJ 07950 (US); MEDEIROS DE SANTA MARIA, Luis Eduardo, Morris Plains, NJ 07950 (US); GRAY, James, Morris Plains, NJ 07950 (US); DODDI, Raghavendra Bhakthavastala, Morris Plains, NJ 07950 (US); AGEMA, Eugene, Morris Plains, NJ 07950 (US)
(74) Representative: Murgitroyd & Company

(56) References cited:
- WO-A2-2012/042232
- US-A- 5 485 954
- US-A1- 2008 161 977
- US-A1- 2015 144 705

## Description

### Technical Field

The present invention generally pertains to building control systems, and more particularly to wall mountable back plates for releasably securing a building control wall module to a wall of a building or other structure.

### Background

Building control systems are often used to control the operation of buildings. Building control systems can include, for example, Heating, Ventilation, and/or Air Conditioning (HVAC) systems, security systems, lighting control systems and other systems.

For example, HVAC systems are often used to control the comfort level within a building or other structure. HVAC systems include an HVAC controller that controls various HVAC components of an HVAC system to affect and/or control one or more environmental conditions within the building. Often, the HVAC controller is mounted to a wall for convenient access. A wall mountable back plate is often first mounted to the wall, and the HVAC controller is then releasably secured to the wall mountable back plate. In some cases, control wires from HVAC components are wired to wiring terminals of the wall mountable back plate. When so provided, the wall mountable back plate often includes pin receiving terminals for receiving pins from the HVAC controller when the HVAC controller engages the wall mountable back plate. The wall mountable back plate may provide the electrical connection between the control wires for the HVAC components and the pins of the HVAC controller.

In some HVAC systems, the HVAC controller may be implemented at least in part via an Equipment Interface Module (EIM). An EIM typically receives inputs from various devices such as thermostats, sensors, other ElM's and the like, and in response, provides control signals to various HVAC components of the HVAC system. In many cases, an EIM is mounted near an HVAC component with control wires connected between the EIM and the HVAC component. A wall mountable back plate may be used to mount the EIM to the wall, and to provide the electrical connection between the control wires of the HVAC components and pins of the EIM.

Other building control systems include a building controller that is mounted to a wall, sometimes via a wall mountable back plate. For example, a security system may include a security panel that is mountable to a wall via a wall mountable back plate. In another example, a lighting control system may include a lighting control panel that is mountable to a wall via a wall mountable back plate. US5485954 discloses a thermostat that includes a subbase having a back surface designed to be mounted conformal with a surface and an inner surface that has a portion of selected electrical components mounted thereon, including a first electrical communication device. WO2012/042232 discloses a mounting unit for mounting an electrical component to a panel has a first member arranged to engage a first side of said panel and a second member arranged to engage the first member and a second, opposite side of said panel, so as to secure the first and second members to opposite sides of the penal through a hold in the panel. What would be desirable is a wall mountable back plate that is eases installation and provides flexibility in wiring options.

### Summary

The invention is set out in accordance with the appended claims. The present disclosure generally pertains to building control systems, and more particularly to wall mountable back plates for releasably securing a building control wall module to a wall of a building or other structure.

A wall mountable back plate includes a housing having a front side and a back side. The back side is configured to be mountable toward a wall. The housing defines a field wire receiving aperture through the back side of the housing, wherein the field wire receiving aperture is configured to accommodate one or more field wires such as field wires for controlling an HVAC component (e.g. boiler, furnace, fan. etc.). A terminal block platform is rotatably coupled to the housing. The terminal block platform includes one or more terminal blocks that are configured to connect one or more field wires to one or more terminal pins of an HVAC control module.

A method for installing a wall mountable back plate according to any of claims 1 to 10 is disclosed in claim 11.

The preceding summary is provided to facilitate an understanding of some of the features of the present invention and is not intended to be a full description.

### Brief Description of the Drawings

The invention may be more completely understood in consideration of the following description of various illustrative embodiments of the disclosure in connection with the accompanying drawings, in which:
Figure 1 is a schematic view of an illustrative HVAC system servicing a building or structure;
Figure 2 is a schematic view of an illustrative HVAC control system that may facilitate access and/or control of the HVAC system of Figure 1;
Figure 3 is a perspective view of an illustrative equipment interface module (EIM) assembly that may be used in the HVAC control system of Figures 1 or 2;
Figure 4 is a perspective view of an illustrative wall mountable back plate of the illustrative EIM assembly of Figure 3 in a first configuration;
Figure 5 is a perspective view of an illustrative wall mountable back plate of the illustrative EIM assembly of Figure 3 in a second configuration;
Figures 6A-6F are perspective views of an illustrative wall mountable back plate being mounted to a wall;
Figures 7A-7C are front views an illustrative wall mountable back plate, in part, illustration various configurations;
Figure 8 is a front view of the illustrative wall mountable back plate of the illustrative EIM assembly of Figure 3 in the second configuration;
Figure 9 is a perspective back view of a partially exploded illustrative EIM assembly with wall mountable back plate;
Figures 10A-10C are front views an illustrative wall mountable back plate, in part, illustration various wiring configuration options;
Figure 11 is a perspective view of another illustrative equipment interface module (EIM) assembly that may be used in the HVAC control system of Figures 1 or 2;
Figure 12 is a perspective view of an illustrative wall mountable back plate of the illustrative EIM assembly of Figure 12 in a first configuration; and
Figure 13 is a perspective view of an illustrative wall mountable back plate of the illustrative EIM assembly of Figure 12 in a second configuration.

### Description

The following description should be read with reference to the drawings wherein like reference numerals indicate like elements. The drawings, which are not necessarily to scale, are not intended to limit the scope of the invention. In some of the figures, elements not believed necessary to an understanding of relationships among illustrated components may have been omitted for clarity.

As used in this specification and the appended claims, the singular forms "a", "an", and "the" include the plural referents unless the content clearly dictates otherwise. As used in this specification and the appended claims, the term "or" is generally employed in its sense including "and/or" unless the content clearly dictates otherwise.

The present disclosure is directed generally at building automation systems. Building automation systems are systems that control one or more operations of a building. Building automation systems can include HVAC systems, security systems, fire suppression systems, energy management systems and other systems. While HVAC systems with HVAC controllers such as EIMs are used as an example below, it should be recognized that the concepts disclosed herein can be applied to building automation systems more generally.

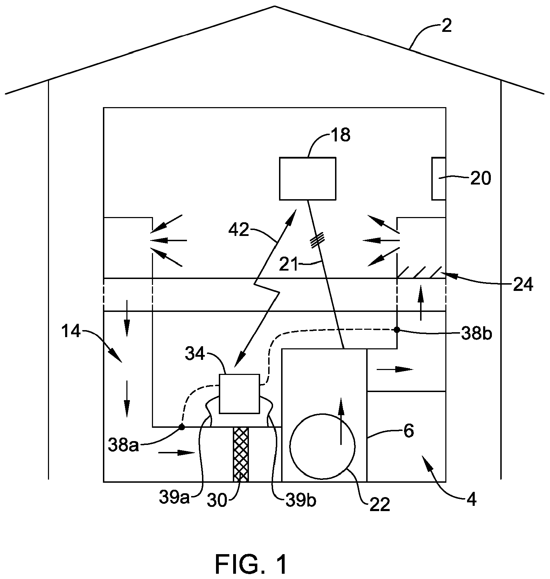

Figure 1 is a schematic view of a building 2 having an illustrative heating, ventilation, and air conditioning (HVAC) system 4. While Figure 1 shows a typical forced air type HVAC system, other types of HVAC systems are contemplated including, but not limited to, boiler systems, radiant heating systems, electric heating systems, cooling systems, heat pump systems, and/or any other suitable type of HVAC system, as desired. The illustrative HVAC system 4 of Figure 1 includes one or more HVAC components 6, a system of ductwork and air vents including a supply air duct 10 and a return air duct 14, and one or more HVAC controllers 18. The one or more HVAC components 6 may include, but are not limited to, a furnace, a boiler, a heat pump, an electric heat pump, a geothermal heat pump, an electric heating unit, an air conditioning unit, a humidifier, a dehumidifier, an air exchanger, an air cleaner, a damper, a valve, and/or the like.

It is contemplated that the HVAC controller(s) 18 may be configured to control the comfort level in the building or structure by activating and deactivating the HVAC component(s) 6 in a controlled manner. The HVAC controller(s) 18 may be configured to control the HVAC component(s) 6 via a wired or wireless communication link 20. In some cases, the HVAC controller(s) 18 may be a thermostat, such as, for example, a wall mountable thermostat, but this is not required in all embodiments. Such a thermostat may include (e.g. within the thermostat housing) or have access to one or more temperature sensor(s) for sensing ambient temperature at or near the thermostat. In some instances, the HVAC controller(s) 18 may be a zone controller, or may include multiple zone controllers each monitoring and/or controlling the comfort level within a particular zone in the building or other structure.

In the illustrative HVAC system 4 shown in Figure 1, the HVAC component(s) 6 may provide heated air (and/or cooled air) via the ductwork throughout the building 2. As illustrated, the HVAC component(s) 6 may be in fluid communication with every room and/or zone in the building 2 via the ductwork 10 and 14, but this is not required. In operation, when a heat call signal is provided by the HVAC controller(s) 18, an HVAC component 6 (e.g. forced warm air furnace) may be activated to supply heated air to one or more rooms and/or zones within the building 2 via supply air ducts 10. The heated air may be forced through supply air duct 10 by a blower or fan 22. In this example, the cooler air from each zone may be returned to the HVAC component 6 (e.g. forced warm air furnace) for heating via return air ducts 14. Similarly, when a cool call signal is provided by the HVAC controller(s) 18, an HVAC component 6 (e.g. air conditioning unit) may be activated to supply cooled air to one or more rooms and/or zones within the building or other structure via supply air ducts 10. The cooled air may be forced through supply air duct 10 by the blower or fan 22. In this example, the warmer air from each zone may be returned to the HVAC component 6 (e.g. air conditioning unit) for cooling via return air ducts 14. In some cases, the HVAC system 4 may include an internet gateway or other device 23 that may allow one or more of the HVAC components, as described herein, to communicate over a wide area network (WAN) such as, for example, the Internet.

In some cases, the system of vents or ductwork 10 and/or 14 can include one or more dampers 24 to regulate the flow of air, but this is not required. For example, one or more dampers 24 may be coupled to one or more HVAC controller(s) 18, and can be coordinated with the operation of one or more HVAC components 6. The one or more HVAC controller(s) 18 may actuate dampers 24 to an open position, a closed position, and/or a partially open position to modulate the flow of air from the one or more HVAC components to an appropriate room and/or zone in the building or other structure. The dampers 24 may be particularly useful in zoned HVAC systems, and may be used to control which zone(s) receives conditioned air from the HVAC component(s) 6.

In many instances, one or more air filters 30 may be used to remove dust and other pollutants from the air inside the building 2. In the illustrative example shown in Figure 1, the air filter(s) 30 is installed in the return air duct 14, and may filter the air prior to the air entering the HVAC component 6, but it is contemplated that any other suitable location for the air filter(s) 30 may be used. The presence of the air filter(s) 30 may not only improve the indoor air quality, but may also protect the HVAC components 6 from dust and other particulate matter that would otherwise be permitted to enter the HVAC component.

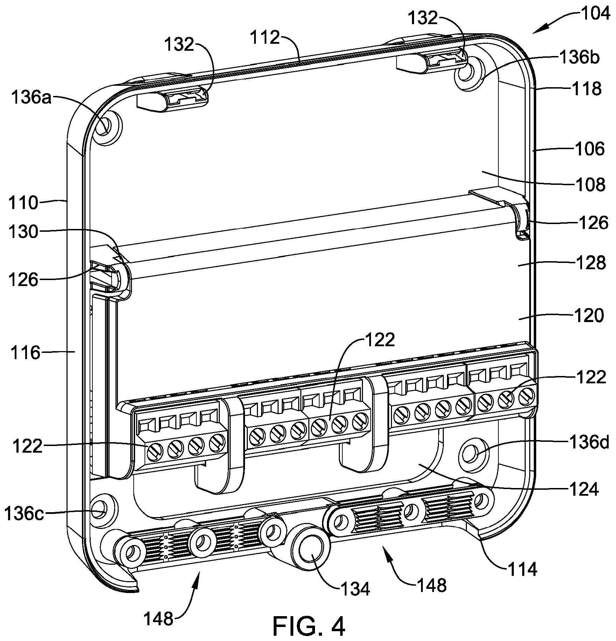

In some cases, and as shown in Figure 1, the illustrative HVAC system 4 may include an equipment interface module (EIM) 34. When provided, the equipment interface module 34 may be configured to control various HVAC components, sometimes under the direction of the thermostat 34 or HVAC controller 18. In some cases, the equipment interface module 34 may receive signals from one or more sensors, and may provide appropriate control signals to one or more HVAC components of the HVAC system. An EIM typically receives inputs from various devices such as thermostats, sensors, other EIM's and the like, and in response, provides control signals to various HVAC components of the HVAC system. In many cases, the EIM is mounted near an HVAC component (e.g. near a boiler, furnace, etc.) with control wires connected between the EIM and the HVAC components to be controlled. In many cases, a wall mountable back plate (e.g. see Figure 4) may be used to mount the EIM to a wall, and to provide the electrical connection between control wires of the HVAC components to be controlled and terminal pins extending from the EIM. When provided, the equipment interface module 34 may be configured to communicate with the HVAC controller 18 via, for example, a wired or wireless communication link 42. In other cases, the equipment interface module 34 may incorporate or be combined with the HVAC controller 18.

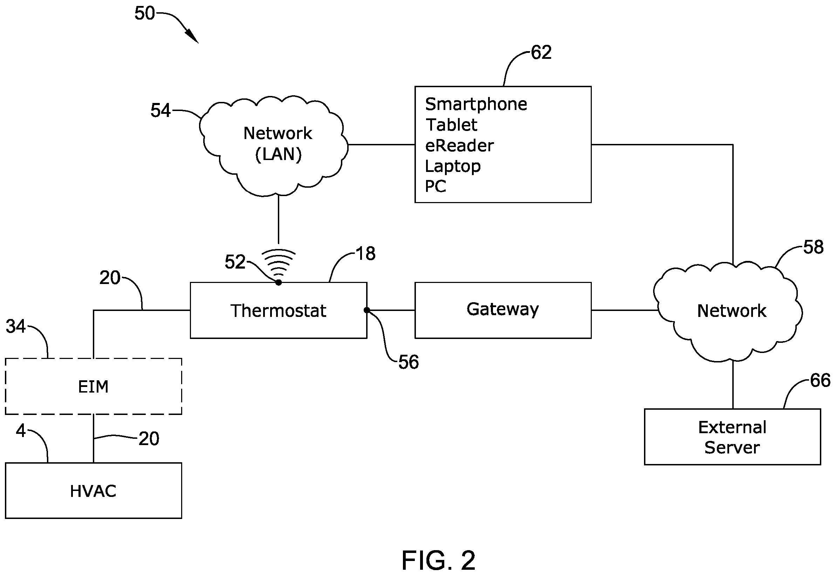

Figure 2 is a schematic view of an illustrative HVAC control system 50 that facilitates remote access and/or control of the illustrative HVAC system 4 shown in Figure 1. The HVAC control system 50 may be considered a building automation system or part of a building automation system. The illustrative HVAC control system 50 includes an HVAC controller, as for example, HVAC controller 18 and/or optionally EIM 34 that is configured to communicate with and control one or more HVAC components 6 of the HVAC system 4. As discussed above, the HVAC controller 18 and/or EIM 34 may communicate with the one or more HVAC components 6 of the HVAC system 4 via a wired or wireless link 20. Additionally, the HVAC controller 18 and/or EIM 34 may communicate over one or more wired or wireless networks that may accommodate remote access and/or control of the HVAC controller 18 and/or EIM 34 via another device such as a smart phone, tablet, e-reader, laptop computer, personal computer, key fob, or the like. As shown in Figure 2, the HVAC controller 18 and/or EIM 34 may include a first communications port 52 for communicating over a first network 54, and in some cases, a second communications port 56 for communicating over a second network 58. In some cases, the first network 54 may be a wireless local area network (LAN), and the second network 58 (when provided) may be a wide area network or global network (WAN) including, for example, the Internet. In some cases, the wireless local area network 54 may provide a wireless access point and/or a network host device that is separate from the HVAC controller 18 and/or EIM 34. In other cases, the wireless local area network 54 may provide a wireless access point and/or a network host device that is part of the HVAC controller 18 and/or EIM 34. In some cases, the wireless local area network 54 may include a local domain name server (DNS), but this is not required for all embodiments. In some cases, the wireless local area network 54 may be an ad-hoc wireless network, but this is not required.

In some cases, the HVAC controller 18 and/or EIM 34 may be programmed to communicate over the second network 58 with an external web service hosted by one or more external web server(s) 66. A non-limiting example of such an external web service is Honeywell's TOTAL CONNECT^{™} web service. The HVAC controller 18 and/or EIM 34 may be configured to upload selected data via the second network 58 to the external web service where it may be collected and stored on the external web server 66. In some cases, the data may be indicative of the performance of the HVAC system 4. Additionally, the HVAC controller 18 and/or EIM 34 may be configured to receive and/or download selected data, settings and/or services sometimes including software updates from the external web service over the second network 58. The data, settings, and/or services may be received automatically from the web service, downloaded periodically in accordance with a control algorithm, and/or downloaded in response to a user request. In some cases, for example, the HVAC controller 18 and/or EIM 34 may be configured to receive and/or download an HVAC operating schedule and operating parameter settings such as, for example, temperature set points, humidity set points, start times, end times, schedules, window frost protection settings, and/or the like from the web server 66 over the second network 58. In some instances, the HVAC controller 18 and/or EIM 34 may be configured to receive one or more user profiles having at least one operational parameter setting that is selected by and reflective of a user's preferences. In still other instances, the HVAC controller 18 and/or EIM 34 may be configured to receive and/or download firmware and/or hardware updates such as, for example, device drivers from the web server 66 over the second network 58. Additionally, the HVAC controller 18 and/or EIM 34 may be configured to receive local weather data, weather alerts and/or warnings, major stock index ticker data, traffic data, and/or news headlines over the second network 58. These are just some examples.

Depending upon the application and/or where the HVAC user is located, remote access and/or control of the HVAC controller 18 and/or EIM 34 may be provided over the first network 54 and/or the second network 58. A variety of remote wireless devices 62 may be used to access and/or control the HVAC controller 18 and/or EIM 34 from a remote location (e.g. remote from the HVAC Controller 18) over the first network 54 and/or second network 58 including, but not limited to, mobile phones including smart phones, tablet computers, laptop or personal computers, wireless network-enabled key fobs, e-readers, and/or the like. In many cases, the remote wireless devices 62 are configured to communicate wirelessly over the first network 54 and/or second network 58 with the HVAC controller 18 and/or EIM 34 via one or more wireless communication protocols including, but not limited to, cellular communication, ZigBee, REDLINK^{™}, Bluetooth, WiFi, IrDA, dedicated short range communication (DSRC), EnOcean, and/or any other suitable common or proprietary wireless protocol, as desired.

In some cases, an application program code (i.e. app) stored in the memory of the remote device 62 may be used to remotely access and/or control the HVAC controller 18 and/or EIM 34. The application program code (app) may be downloaded from an external web service, such as the web service hosted by the external web server 66 (e.g. Honeywell's TOTAL CONNECT^{™} web service) or another external web service (e.g. ITUNES^{®} or Google Play). In some cases, the app may provide a remote user interface for interacting with the HVAC controller 18 at the user's remote device 62. For example, through the user interface provided by the app, a user may be able to change operating parameter settings such as, for example, temperature set points, humidity set points, start times, end times, schedules, window frost protection settings, accept software updates and/or the like. Communications may be routed from the user's remote device 62 to the web server 66 and then, from the web server 66 to the HVAC controller 18 and/or EIM 34. In some cases, communications may flow in the opposite direction such as, for example, when a user interacts directly with the HVAC controller 18 and/or EIM 34 to change an operating parameter setting such as, for example, a schedule change or a set point change. The change made at the HVAC controller 18 may be routed to the web server 66 and then from the web server 66 to the remote device 62 where it may reflected by the application program executed by the remote device 62.

In some cases, a user may be able to interact with the HVAC controller 18 and/or EIM 34 via a user interface provided by one or more web pages served up by the web server 66. The user may interact with the one or more web pages using a variety of internet capable devices to effect a setting or other change at the HVAC controller 18 and/or EIM 34, and in some cases view usage data and energy consumption data related to the usage of the HVAC system 4. In some cases, communication may occur between the user's remote device 62 and the HVAC controller 18 and/or EIM 34 without being relayed through a server such as external server 66. These are just some examples.

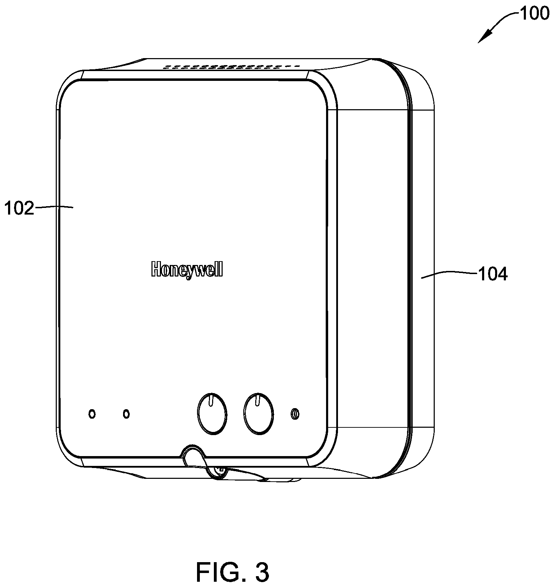

Figure 3 is a perspective view of an illustrative EIM assembly 100. The EIM assembly 100 may include an HVAC controller 18, such as a thermostat, but this is not required or even desired in some cases. In some instances, the EIM assembly 100 may be considered as an example of the equipment interface module 34 referenced in Figure 1. In some embodiments, the EIM assembly 100 may include an EIM 102 and a wall mountable back plate 104. While the assembly 100 is described as an EIM assembly, it is contemplated that similar assemblies may be used for mounting thermostats, control panels, and/or other control modules to a wall or other surface. As will be illustrated, the wall mountable back plate 104 may be configured to accommodate field wires that enter from, for example, a rear or bottom of the wall mountable back plate 104. When so provided, the wall mountable back plate 104 may provide an electrical connection between wiring terminals of the EIM 102 and field wires (not illustrated) of the HVAC system 4 (Figures 1 and 2). In the example shown, the wall mountable back plate 104 also provides a mechanical connection to the EIM 102 and may be used to secure the EIM 102 in place relative to a vertical surface such as a wall.

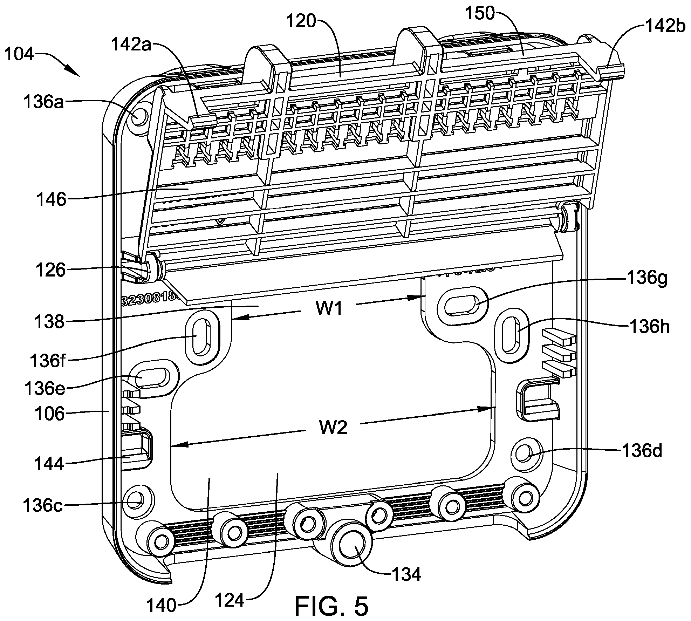

The wall mountable back plate 104 will be described in more detail with respect to Figure 4 which is a perspective view of the illustrative wall mountable back plate 104 in a first, or operational, position and Figure 5 which is a perspective view of the illustrative wall mountable back plate 104 in a second, or installation, position. As shown in Figures 4-5, the illustrative wall mountable back plate 104 may have a housing 106 with a front side 108 and a back side 110. The back side 110 of the wall mountable back plate 104 may be configured to be mounted or mountable towards a wall, or other surface. The housing 106 may further include a top edge or side 112, a bottom edge or side 114 positioned opposite from the top edge 112, a left edge or side 116, and a right edge or side 118 positioned opposite from the left edge 116. The left and right edges 116, 118 may connect the top and bottom edges 112, 114 and vice versa. The use of front, back, top, bottom, left and right are merely illustrative and are not intended to limit the structure of the housing to a particular orientation. The housing 106 may further define a field wire receiving aperture 124 extending through the housing 106 from the back side 110 to the front side 108. Alternatively, or additionally, the field wire receiving aperture 124 may include one or more bottom openings 148 extending through the bottom edge 114 of the housing. The field wire receiving aperture 124 may be configured to accommodate one or more field wires (not explicitly shown) extending from a wall or other surface and connected to one or more HVAC components such as a boiler, fan and/or the like. As best seen in Figure 5, the field wire receiving aperture 124 may include a first region 138 having a first width W1 and a second region 140 having a second width W2 greater than the first width W1. This may allow the field wire receiving aperture 124 to accommodate a plurality of field wires while allowing for flexibility in the positioning of the mounting apertures 136, which are described in more detail below.

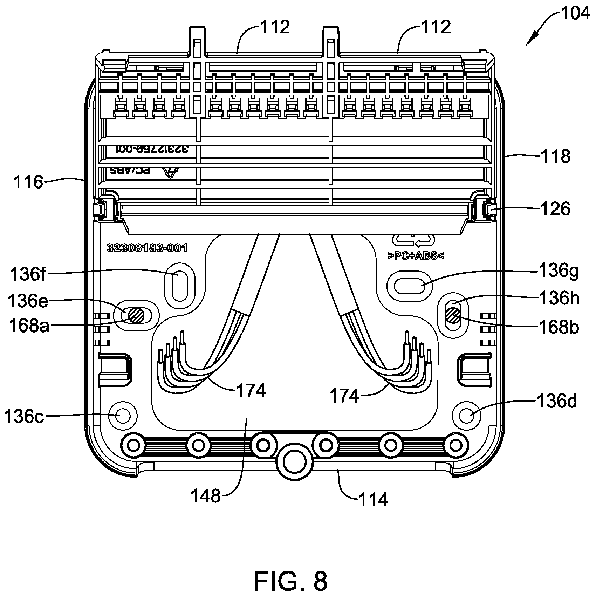

The wall mountable back plate 104 may further include a terminal block platform 120 including one or more terminal blocks 122. The terminal block platform 120 may be rotatable between an operational position (shown in Figure 4) and an installation position (shown in Figure 5). It is contemplated that the terminal block platform 120 may be positioned at any position between the operational position and a fully open position. Any of these positions, other than the operational position, may be considered an installation position. In some instances, the installation position may generally correspond to a fully open or fully rotated position, while in other instances, the installation position may be any position between the operational position and the fully open position and may include the fully open position. It is contemplated that the installation position may be selected by the installer to be a position which best eases installation for the installer. When the terminal block platform 120 is in the operational configuration, the one or more terminal blocks 122 may be positioned or configured to receive one or more terminal pins (see Figure 8B) of the EIM 102 within one or more terminal pin receiving apertures in the terminal blocks 122. It is contemplated that in the operational configuration, the terminal blocks 122 may be oriented such that the terminal pins may be received within the terminal pin receiving apertures of the terminal blocks 122 when the EIM 102 is moved along a straight line path towards the wall that the wall mountable back plate 104 is mounted. When in the operational position, the terminal block platform 120 may cover at least a portion of the field wire receiving aperture 124 as shown. In some embodiments, the terminal block platform 120 may cover a majority (e.g. 50% or more) of the field wire receiving aperture 124. This is just an example. The terminal block platform 120 may cover 10% or more, 25% or more, 50% or more, 75% or more, 90% or more of the field wire receiving aperture 124, as desired. More is generally better.

In the operational position, the terminal block platform 120 may cover much or all of the field wire receiving aperture 124 and may hide much of the field wires from view, providing a clean and un-cluttered look. Also, the field wires may be confined and pulled out of the way to help prevent the field wires from interfering with the mechanical connection between the wall mountable back plate 104 and the EIM 102 when the EIM 102 is brought into engagement with the wall mountable back plate 104. Moreover, since in some cases the field wires may carry a line-voltage (e.g. 240V), limiting visibility and access to the field wires by hiding much of the field wires behind the terminal block platform 120 may help improve the overall safety of the wall mountable back plate 104, particularly in the event a home owner or other untrained person were to remove the EIM 102 and gain access to the wall mountable back plate 104.

The terminal block platform 120 may be rotatably coupled to the housing 106 at a pair of hinges 126, or other rotation mechanism to move the terminal block platform 120 between the operational position and an open or installation position. The terminal block platform 120 may rotate away from the housing 106. This has the advantage that the back side 146 of the terminal block platform 120 and/or a bottom surface of the terminal blocks 122 are more accessible to an installer and addresses the problem of providing improved ease of installation. Preferably, the bottom side 150 of the terminal block platform 120 may be configured to rotate away from the housing 106 and up towards the top edge 112 of the housing 106 along an arc. This has the advantage of facilitating a connection between the one or more field wires and the one or more terminal blocks 122 thus further improving the ease of installation. Further, rotation of the terminal block platform 120 away from the housing 106 may expose more of the field wire receiving aperture 124 relative to when the terminal block platform 120 is in the operational position, which may help maximize the space for accessing the field wires during installation and thereby improve ease of installation. Rotatably coupling the terminal block platform 120 to the housing 106 may also allow the installer to rotate the terminal blocks 122 to a desired and/or comfortable position so the one or more field wires from the one or more HVAC components can more easily be inserted and secured to the terminal blocks 122, thus greatly easing installation. Additionally, rotation of the terminal block platform 120 may allow an installer to access one or more mounting apertures 136e, 136f, 136g, 136h which in some cases may be positioned behind the terminal block platform 120, again for a clean and uncluttered look.

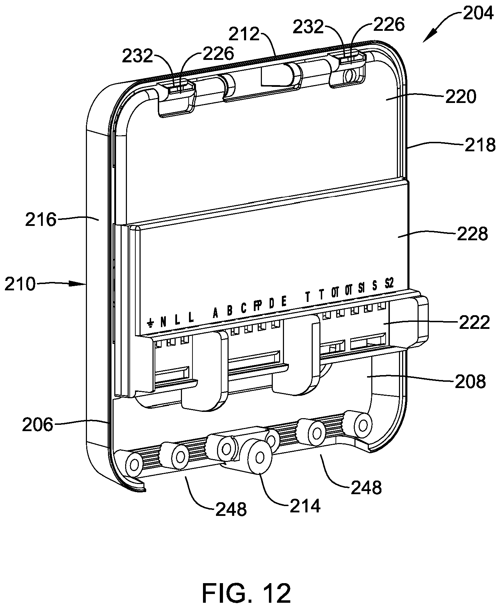

In some instances, the hinges 126 may be positioned along the left edge 116 and the right edge 118 of the housing 106 at a point between the top edge 112 and the bottom edge 114. This is just an example. In some instances, the hinges 126 may be located along the top edge 112 of the housing, as shown in Figures 12-14. The hinges 126 may be any mechanism that allows the terminal block platform 120 to rotate relative to the housing 106. In some embodiments, the hinges 126 may include a stop mechanism configured to limit rotation of the terminal block platform 120. For example, the hinge 126 may include an angled surface 130 configured to engage a front surface 128 of the housing when fully opened. As the terminal block platform 120 is rotated away from the wall and in a direction towards the top edge 112 of the housing 106, the front surface 128 of the terminal block platform 120 may engage the angled surface 130, or stop mechanism, of the hinge 126 thus limiting further rotation of the terminal block platform 120. The stop mechanism may prevent the terminal block platform 120 from rotating too far so as to engage latch mechanism 132. This may limit collateral damage to the latch mechanism 132 and/or the terminal block platform 120. Providing sufficient rotation to ease installation while also limiting rotation with a controlled stop mechanism is preferred. The stop mechanism may be configured to limit rotation of the terminal block platform 120 to 180° or less, 145° or less, 130° or less, 100° or less, 90° or less, etc. These are just examples. Figure 5 shows the terminal block platform 120 in the fully open position and engaging the stop mechanism.

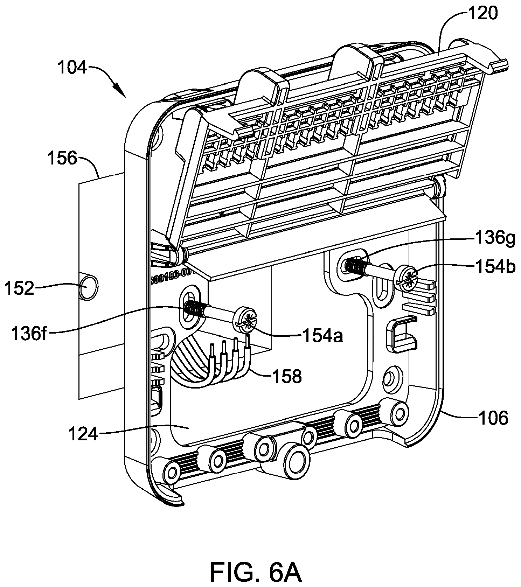

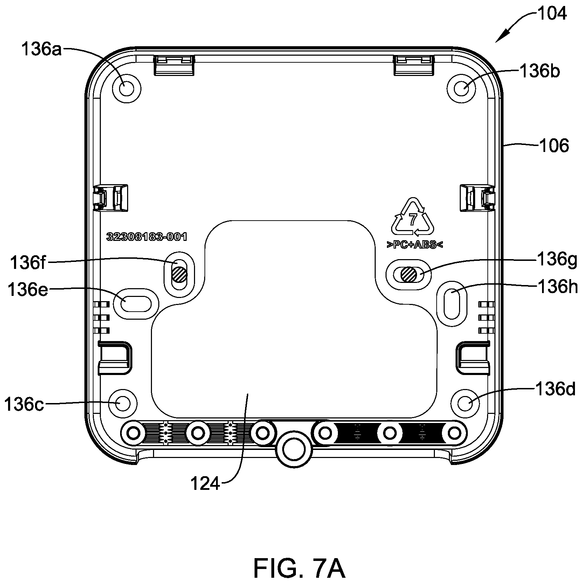

Referring to Figures 4-5, the housing 106 may include a plurality of mounting apertures 136a, 136b 136c, 136d, 136e, 136f, 136g, 136h (collectively, 136). The mounting apertures 136 may be spaced from one another and positioned such that various combinations of the apertures 136 may be utilized to allow the housing 106 to be attached to a variety of different junction boxes and/or wall configurations, as will be described in more detail with respect to Figures 6A-6F and 7A-7C. In some cases, one or more of the mounting apertures 136 may have an elongated shape to allow for more vertical and/or horizontal flexibility when aligning the mounting apertures 136 with a mating aperture in a junction box and/or mounting surface. When the terminal block platform 120 is in the operational position (shown in Figure 4), the terminal block platform 120 may cover at least some of the mounting apertures 136e, 136f, 136g, 136h, although this is not required. In some embodiments, the terminal block platform 120 may be sized and shaped to cover a majority of the mounting apertures 136 (e.g. more than half) when in the operational position, which may present a clean and un-cluttered look. These are just examples. The terminal block platform 120 may cover as many of or as few of the mounting apertures 136 as desired.

Generally, the housing 106 may have a generally square or rectangular shape and may include a mounting aperture 136a, 136b 136c, 136d positioned in or adjacent to each of the four corners of the housing 106. The wall mountable back 104 may further include two or more mounting apertures 136f, 136g positioned adjacent to the first region 138 of the field wire receiving aperture 124 and two or more mounting apertures 136f, 136g positioned adjacent to the second region 140 of the field wire receiving aperture 124. These are just examples. It is contemplated that the housing 106 may include more than eight or fewer than eight mounting apertures 136, as desired. It is further contemplated that the mounting apertures 136 may be arranged in configurations other than that described with respect to Figures 4 and 5.

The terminal block platform 120 may include one or more releasable latches 142a, 142b (collectively 142), or fastening mechanisms, for releasably securing the terminal block platform 120 to the housing 106 in the operation position. The latches 142 may be configured to engage a mating latch structure 144 on the housing 106. In some instances, the latches 142 and mating latch structure 144 may be disengaged from one another through the application of a pushing or pulling force on the latches 142. In the example shown, a first latch 142a may be positioned along the left edge 116 of the housing 106 and a second latch 142b may be positioned along the right edge 118 of the housing 106. However, it is contemplated that the latches 142, when provided, may be arranged in any suitable configuration. Further, there may be more than two latches 142, or fewer than two latches 142, as desired.

It is further contemplated that the hinges 126 and the latches 142 may be configured to space the terminal block platform 120 a distance from the wall or mounting surface. For example, the hinges 126 and latches 142 may extend a distance (e.g. away from front surface 128) beyond a back surface 146 of the terminal block platform 120 such that there is a gap between the wall and the back surface 146 of the terminal block platform 120 . This may form a cavity or recess for accommodating the field wires, which may help reduce bending and/or kinking of the field wires. It is further contemplated that maintaining a space between the back surface 146 of the terminal block platform 120 and the mounting surface may allow field wires to enter the wall mountable back plate 104 via the field wire receiving aperture 124 (e.g. for a recessed wall box, hole in the wall, surface mounted wall box, etc.) or through one or more bottom openings 148 (e.g. for a surface mounted wall box or surface mounted configuration, etc.) in the bottom edge 114 of the housing 106.

The housing 106 may further include one or more latch mechanisms 132 configured to releasably secure the EIM 102 to the wall mountable back plate 104. The latch mechanisms 132 may be configured to cooperate with a mating latch mechanism on the EIM 102. In some instances, the EIM may be removed from the wall mountable back plate 104 through a pulling and/or rotating motion. The housing 106 may further be provided with a fixation aperture 134. The fixation aperture 134 may be configured to receive a screw, fastener, or other fixation mechanism configured to releasable secure the EIM 102 to the wall mountable back plate 104, when desired. It is contemplated that the fixation mechanism may help prevent the EIM 102 from being inadvertently detached from the wall mountable back plate 104 while still allowing for easy attachment and/removal of the EIM 102 to/from the wall mountable back plate 104. While the latch mechanisms 132 are illustrated along the top edge 112 of the housing, the latch mechanisms 132 may be positioned anywhere on the housing, including but not limited to the bottom edge 114, the left edge 116, the right edge 118, or within a central region.

To install the wall mountable back plate 104 and the EIM 102 to a wall or other mounting surface, an installer may first secure the housing 106 to the wall or mounting surface (or a junction box or other structure attached to the wall). As described above, the location and size of the mounting apertures 136 used to secure the housing 106 may be strategically placed to accommodate a variety of different types or styles of junction boxes used in different countries or geographical locations. Figures 6A-6F are perspective views of the illustrative wall mountable back plate 104 being mounted to a wall.

In Figure 6A, two fasteners 154a, 154b (collectively 154), or other fastening mechanism may be received through two of the mounting apertures 136f, 136g. The fasteners 154 may pass through the mounting apertures 136f, 136g and engage corresponding apertures 152 in a generally square or rectangular recessed junction box 156. The terminal block platform 120 may be raised or in an installation position to facilitate access to the mounting apertures 136f, 136g. One or more field wires 158 may extend from the junction box 156. When the fasteners 154 are fully engaged with the mounting apertures 136f, 136g and corresponding apertures 152 in the junction box 156, the field wires 158 may extend through the field wire receiving aperture 124.

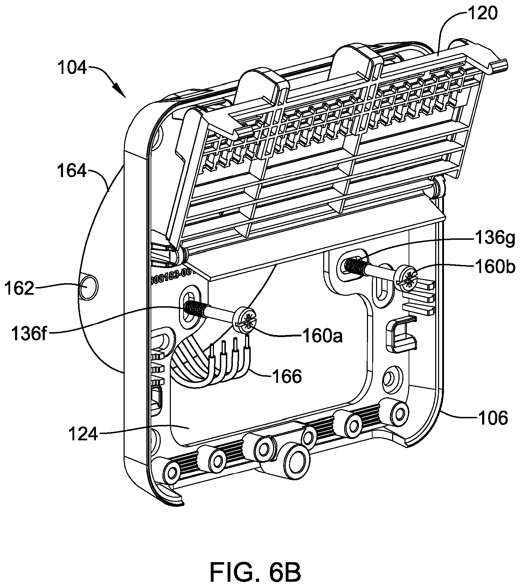

In Figure 6B, two fasteners 160a, 160b (collectively 160), or other fastening mechanism may be received through two of the mounting apertures 136f, 136g. The fasteners 160 may pass through the mounting apertures 136f, 136g and engage corresponding apertures 162 in a generally circular recessed junction box 164. The terminal block platform 120 may be raised or in an installation position to facilitate access to the mounting apertures 136f, 136g. One or more field wires 166 may extend from the junction box 164. When the fasteners 160 are fully engaged with the mounting apertures 136f, 136g and corresponding apertures 162 in the junction box 164, the field wires 166 may extend through the field wire receiving aperture 124.

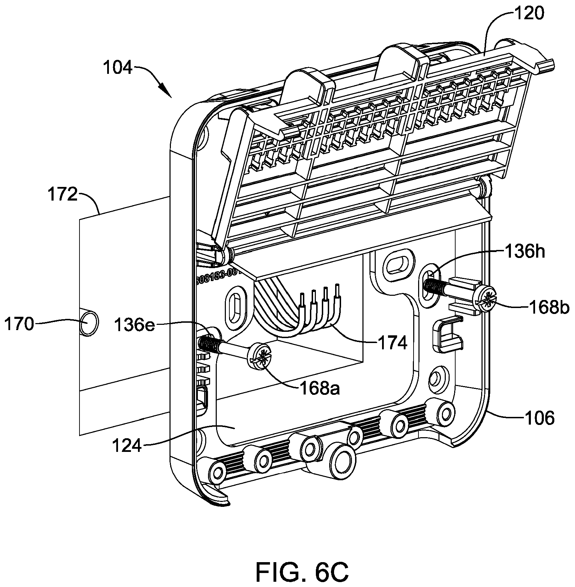

In Figure 6C, two fasteners 168a, 168b (collectively 168), or other fastening mechanism may be received through two of the mounting apertures 136e, 136h. The fasteners 168 may pass through the mounting apertures 136e, 136h and engage corresponding apertures 170 in a generally square or rectangular recessed junction box 172. In some instances, the junction box 172 shown in Figure 6C may be sized and shaped differently from the junction box 156 shown in Figure 6A. Alternatively, or additionally, the apertures 170 in the junction box 172 may be spaced differently than the apertures of junction box 156. The terminal block platform 120 may be raised or in an installation position to facilitate access to the mounting apertures 136e, 136h. One or more field wires 174 may extend from the junction box 172. When the fasteners 168 are fully engaged with the mounting apertures 136e, 136h and corresponding apertures 170 in the junction box 172, the field wires 174 may extend through the field wire receiving aperture 124.

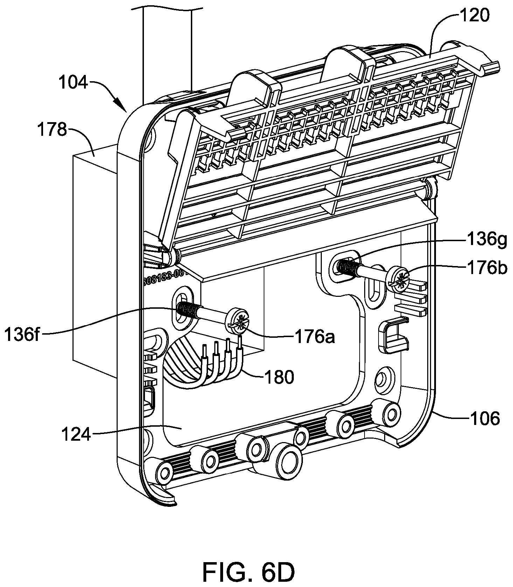

In Figure 6D, two fasteners 176a, 176b (collectively 176), or other fastening mechanism may be received through two of the mounting apertures 136f, 136g. The fasteners 176 may pass through the mounting apertures 136f, 136g and engage corresponding apertures (not explicitly shown) in a generally square or rectangular surface mounted wall junction box 178. The terminal block platform 120 may be raised or in an installation position to facilitate access to the mounting apertures 136f, 136g. One or more field wires 180 may extend from the junction box 178. When the fasteners 176 are fully engaged with the mounting apertures 136f, 136g and corresponding apertures in the junction box 178, the field wires 180 may extend through the field wire receiving aperture 124.

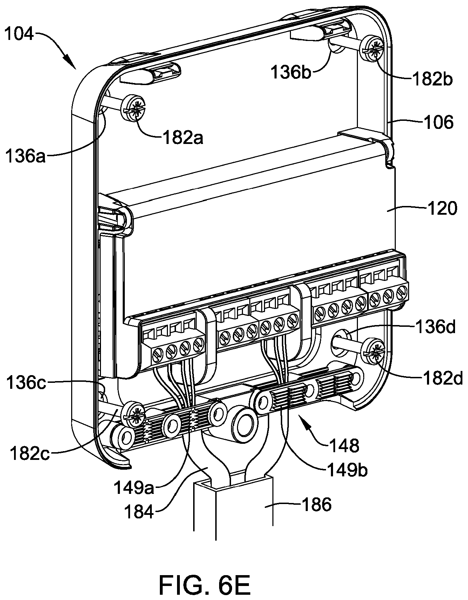

In Figure 6E, four fasteners 182a, 182b, 182c, 182d (collectively 182), or other fastening mechanism may be received through four of the mounting apertures 136a, 136b, 136c, 136d. The fasteners 182 may pass through the mounting apertures 136a, 136b, 136c, 136d and engage the wall or surface behind the wall mountable back plate 104. The terminal block platform 120 may be raised or in an installation position to facilitate access to the mounting apertures 136c, 136d, however this is not required as all four mounting apertures 136a, 136b, 136c, 136d may be accessible when the terminal block platform 120 is in the operational position. If the wall mountable back plate 104 is mounted to the wall with the terminal block platform 120 in the operational configuration, the terminal block platform 120 may be raised or rotated upwardly away from the floor when the field wires 184 are connected to the wall mountable back plate 104 (e.g. via terminal blocks 122). In Figure 6E, the field wires 184 are shown extending from a conduit 186 and through one or more bottom openings 148 in the housing 106. The conduit 186 may be attached to the surface of the wall that the wall mountable back plate 104 is mounted, and may extend in an upward direction away from the floor and toward and through the bottom openings 148 in the housing 106. The field wires 184 may be connected to appropriate terminals of terminal blocks 122, as shown in Figure 6E. Clamps 149a and 149b may be provided to clamp the one or more field wires in place relative to the housing 106 to help prevent the weight of the field wires 184 from pulling the field wires out of the terminal blocks 122. This may make the connection more reliable.

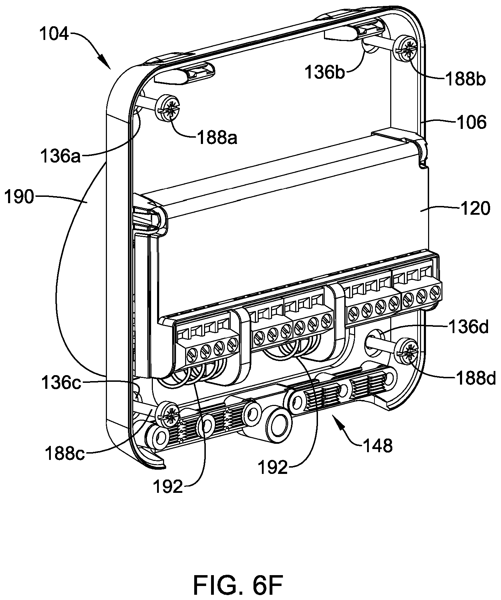

In Figure 6F, four fasteners 188a, 188b, 188c, 188d (collectively 188), or other fastening mechanism may be received through four of the mounting apertures 136a, 136b, 136c, 136d. The fasteners 188 may pass through the mounting apertures 136a, 136b, 136c, 136d and engage the wall or surface behind the wall mountable back plate 104 with one or more field wires 192 fed directly through an opening 190 in the plaster board and/or wall. The terminal block platform 120 may be raised or in an installation position to facilitate access to the mounting apertures 136a, 136b, 136c, 136d, however this is not required as all four mounting apertures 136a, 136b, 136c, 136d are accessible when the terminal block platform 120 is in the operational position. If the wall mountable back plate 104 is mounted to the wall with the terminal block platform 120 in the operational configuration, the terminal block platform 120 may be raised or rotated upwardly away from the floor when the field wires 192 are connected to the wall mountable back plate 104 (e.g. via terminal blocks 122). By rotating the terminal block platform 120 upwardly, the installer may be provided easier and more convenient access to the openings in the bottom surface of the terminal blocks 122 that receive the field wires. Without the ability to rotate the terminal block platform upwardly, the installer would have to bend down and look up at the bottom surface of the terminal blocks 122 and attempt to insert the field wires into the appropriate openings in the terminal block 122.

In Figure 6F, the one or more field wires 192 may extend through the wall opening 190. When the fasteners 188 are fully engaged with the mounting apertures 136a, 136b, 136c, 136d and the wall or mounting surface, the field wires 192 may extend through the field wire receiving aperture 124 in the housing 106. By rotating the terminal block platform 120 upwardly, an installer is provided with better access to the field wire receiving aperture 124 in the housing 106 and thus the field wires 192. When done, the installer may rotate the terminal block platform 120 downward to the operational position, as seen in Figure 6F. In the operational position, the terminal block platform 120 may cover much or all of the field wire receiving aperture 124 and may hide much of the field wires from view, providing a clean and un-cluttered look. Also, the field wires may be confined and pulled out of the way to help prevent the field wires from interfering with the mechanical connection between the wall mountable back plate 104 and the EIM 102 when the EIM 102 is brought into engagement with the wall mountable back plate 104. Moreover, since in some cases the field wires may carry a line-voltage (e.g. 240V), limiting visibility and access to the field wires by hiding much of the field wires behind the terminal block platform 120 may help improve the overall safety of the wall mountable back plate 104, particularly in the event a home owner or other untrained person were to remove the EIM 102 and gain access to the wall mountable back plate 104.

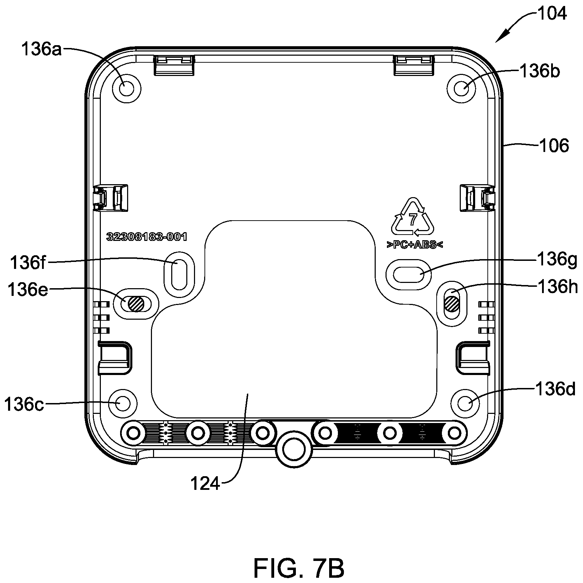

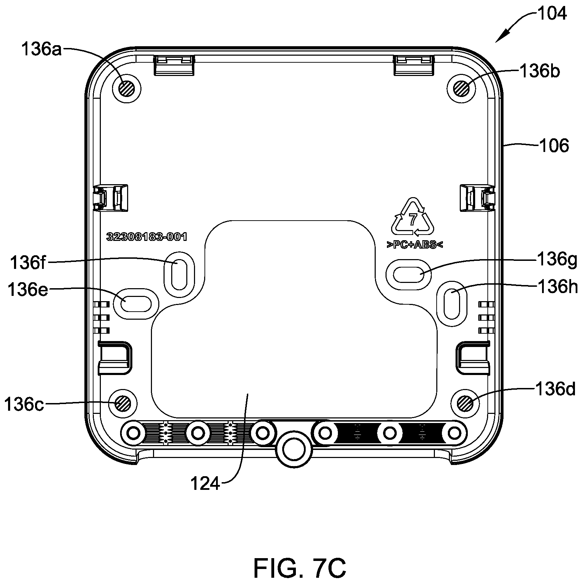

Figures 7A-7C illustrate a front view of the wall mountable back plate 104 with the terminal block platform 120 removed for clarity to illustrate the various mounting aperture 136 combinations described with respect to Figures 6A-6F. Figure 7A illustrates an embodiment in which the fixation mechanisms or fasteners are received in the mounting apertures 136f, 136g adjacent to the first region 138 of the field wire receiving aperture 124. The fixation combination of Figure7A may be used in the shown in Figures 6A, 6B, and 6D. Figure 7B illustrates an embodiment in which the fixation mechanisms or fasteners are received in the mounting apertures 136e, 136h adjacent to the second region 140 of the field wire receiving aperture 124. The fixation combination of Figure7B may be used in the shown in Figure 6C. Figure 7C illustrates an embodiment in which the fixation mechanisms or fasteners are received in the mounting apertures 136a, 136b, 136c, 136d adjacent to the corners of the housing 106. The fixation combination of Figure7C may be used in the shown in Figures 6E and 6F. These are just examples and are not intended to limit the mounting of the housing 106 to any specific combination of mounting apertures 136 or preclude the use of mounting arrangements other than what is shown and described.

Figure 8 illustrates a front view of the wall mountable back plate 104 mounted as described with respect to Figure 6C, with the terminal block platform 120 rotated into an installation position. It should be understood that the method of connecting the field wires 174 may be same as described with respect to Figure 8 with any of the various configurations described above. Once the wall mountable back plate 104 has been mounted to the wall, the one or more field wires 174 may be pulled through the field wire receiving aperture 124. As noted above, if the wall mountable back plate 104 has been mounted with surface mounted wiring (e.g. Figure 6E), the field wires may enter the housing 106 from or be pulled through one or more bottom openings 148. If the terminal block platform 120 was not rotated into an installation position for the mounting of the wall mountable back plate 104, the terminal block platform 120 may be rotated from the operational position towards the top edge 112 of the housing 106 into an installation position to facilitate manual connection of the field wires 174 with the terminal blocks 122 by an installer. Once the terminal block platform 120 is in an installation position as shown in Figure 8, the installer may manually connect one or more field wires 174 to the terminal blocks 122. As described above, the installation position may be any position between the operational position and a fully open position. In some instances, further upward rotation of the terminal block platform 120 may be prevented by a stop mechanism, although this is not required. In some cases, frictional forces at the hinges 126 may maintain the terminal block platform 120 in the selected installation position while the installer is connecting the field wires 174 to the terminal blocks 122. A manual force may be required to rotate the terminal block platform 120 downwards towards and into the operational configuration. Once the field wires 174 have been connected with the terminal blocks 122, the terminal block platform 120 may be rotated downwards towards and into the operational configuration. When so provided, the terminal block platform 120 may be rotated until the releasable latches 142 engage the mating structures 144 one the housing 106.

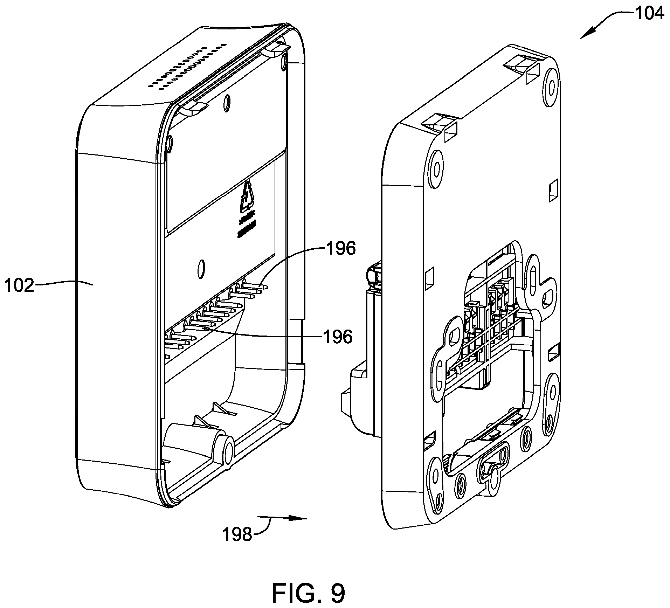

Once the terminal block platform 120 has been returned to the operational position, the EIM 102 may be connected to the wall mountable back plate 104, as shown in Figure 9. This may be performed by moving the EIM 102 (or other HVAC control module) in a straight line path 198 towards the wall mountable back plate 104 such that the one or more terminal blocks 122 receive one or more terminal pins 196 of the EIM 102. It is further contemplated that the EIM 102 may be advanced until a latch mechanism on the EIM engages one or more latch mechanisms 132 on the housing 106. A fixation mechanism, fastener, or screw, may then be secured through an opening adjacent to the lower edge of the EIM 102 and the fixation aperture 134 in the EIM to further secure the EIM 102 to the wall mountable back plate 104.

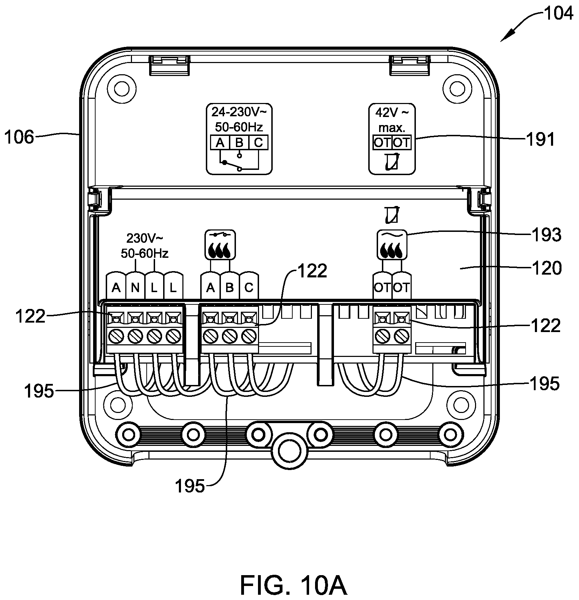

The illustrative wall mountable back plate 104 may be configured to be used with various HVAC system configurations. Figures 10A-10C illustrate various wiring configurations that may be used with different HVAC system configurations. Figure 10A illustrates a front view of an illustrative wall mountable back plate 104 that has been wired for wired communication with one or more HVAC components and/or control modules. The housing 106 and/or terminal block platform 120 may include one or more visual markings 191, 193 configured to provide direction to the installer. In some instances, not all of the available terminals may be provided with terminal blocks 122 depending on the application. Terminal wires 195 may be connected with the appropriate or corresponding terminal blocks 122 as dictated by the application.

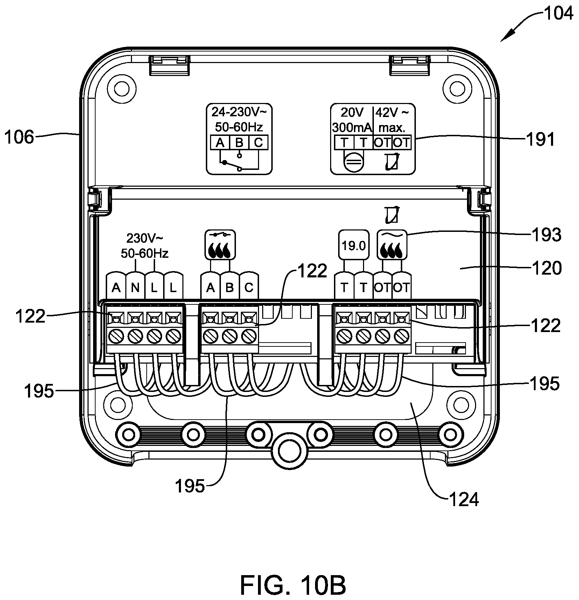

Figure 10B illustrates a front view of an illustrative wall mountable back plate 104 that has been wired for wired communication with one or more HVAC components and/or control modules. It is contemplated that the configuration illustrated in Figure 10B may include additional field wires 195 relative to the configuration shown in Figure 10A. This is just an example. The housing 106 and/or terminal block platform 120 may include one or more visual markings 191, 193 configured to provide direction to the installer. The visual markings 191, 193 may be different from the markings illustrated in Figure 10A to guide an installer in installing the particular configuration. In some instances, not all of the available terminals may be provided with terminal blocks 122 depending on the application. Terminal wires 195 may be connected with the appropriate or corresponding terminal blocks 122 as dictated by the application.

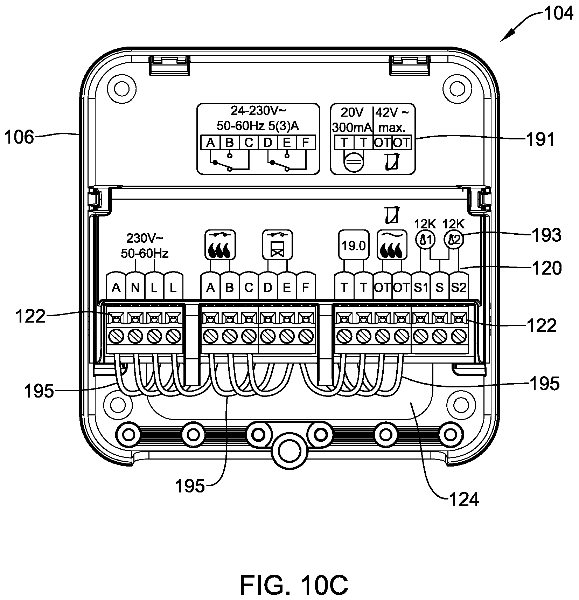

Figure 10C illustrates a front view of an illustrative wall mountable back plate 104 that has been wired for wired communication with one or more HVAC components and/or control modules and also include additional communication and/or control options. It is contemplated that the configuration illustrated in Figure 10C may allow for the inclusion of additional field wires 195 relative to the configurations shown in Figures 10A and 10B. However, not every terminal block 122 may be used in every application. This is just an example. The housing 106 and/or terminal block platform 120 may include one or more visual markings 191, 193 configured to provide direction to the installer. The visual markings 191, 193 may be different from the markings illustrated in Figure 10A and/or 10B to guide an installer in installing the particular configuration. In some instances, not all of the available terminals may be provided with terminal blocks 122 depending on the application. Terminal wires 195 may be connected with the appropriate or corresponding terminal blocks 122 as dictated by the application.

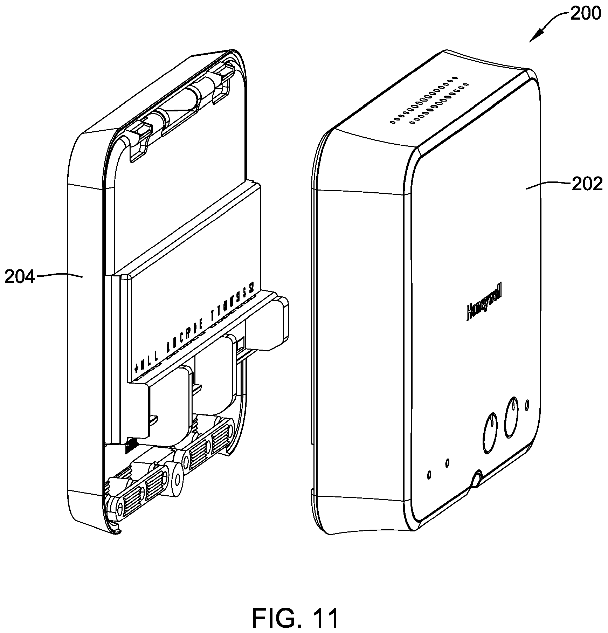

Figure 11 is a perspective, partially exploded, view of another illustrative equipment interface assembly (EIM) 200. The EIM assembly 200 may be similar in form and function to the assembly 100 described above. The EIM assembly 200 may be installed in a similar manner to the EIM assembly 100 described above. In some instances, the EIM assembly 200 may be considered as an example of the equipment interface module 34 referenced in Figure 1. In some embodiments, the EIM assembly 200 may include an EIM 202 and a wall mountable back plate 204. While the assembly 200 is described as an EIM assembly, it is contemplated that similar assemblies may be used for mounting thermostats and/or other HVAC control modules to a wall or other surface. As will be illustrated, the wall mountable back plate 204 may be configured to accommodate field wires that enter from a rear of the wall mountable back plate 204. When so provided, the wall mountable back plate 204 may provide an electrical connection between terminals of the EIM 202 and field wires (not illustrated) of the HVAC system 4 (Figures 1 and 2). In the example shown, the wall mountable back plate 204 also provides a mechanical connection to the EIM 202 and thus may be used to secure the EIM 202 in place relative to a vertical surface such as a wall.

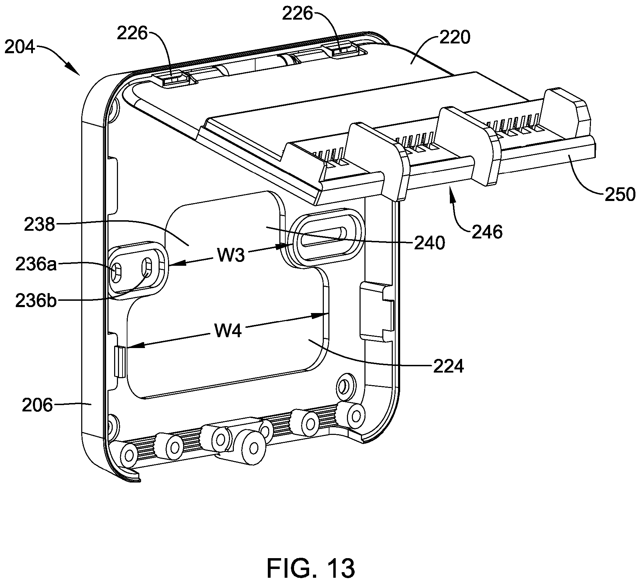

The wall mountable back plate 204 will be described in more detail with respect to Figure 12, which is a perspective view of the illustrative wall mountable back plate 204 in a first, or operational, position, and Figure 13, which is a perspective view of the illustrative wall mountable back plate 204 in a second, or installation, position. The wall mountable back plate 204 may have a housing 206 with a front side 208 and a back side 210. The back side 210 of the wall mountable back plate 204 may be configured to be mounted or mountable towards a wall, or other surface. The housing 206 may further include a top edge or side 212, a bottom edge or side 214 positioned opposite from the top edge 212, a left edge or side 216, and a right edge or side 218 positioned opposite from the left edge 216. The left and right edges 216, 218 may connect the top and bottom edges 212, 214 and vice versa. The use of front, back, top, bottom, left and right are merely illustrative and are not intended to limit the structure of the housing to a particular orientation. The housing 206 may define a field wire receiving aperture 224 (see, for example, Figure 13) extending through the housing 206 from the back side 210 to the front side 208. Alternatively, or additionally, the housing 206 may be configured to remove one or more portions 248 of the bottom edge 214 such that the field wire receiving aperture 224 may extend through the bottom edge 214 of the housing 206. The field wire receiving aperture 224 may be configured to accommodate one or more field wires (not explicitly shown) extending from a wall or other surface. The field wire receiving aperture 224 may having an "I" shape, although this is not required. The field wire receiving aperture 224 may include an intermediate region 238 having a first width W3 and a top and bottom region 240 positioned on either side of the intermediate region 238. The top and bottom regions of the field wire receiving aperture 224 may have a second width W4 greater than the first width W3. This may allow the field wire receiving aperture 224 to accommodate a plurality of field wires while allowing for flexibility in the positioning of the mounting apertures 236, which are described in more detail below.

The wall mountable back plate 204 may further include a terminal block platform 220 including one or more regions 222 for receiving a plurality of terminal blocks (terminal blocks not shown in Figures 12-13). The terminal block platform 220 may be rotatable between an operational position (shown in Figure 12) and an installation position (shown in Figure 13). It is contemplated that the terminal block platform 220 may be positioned at any position between the operational position and a fully open position, and any of these intermediate positions may be considered an installation position. In some instances, the installation position may generally correspond to a fully open or fully rotated position, while in other instances, the installation position may be any position between the operational position and a fully open position and may include the fully open position. It is contemplated that the installation position may be selected by the installer to be a position which best eases installation for the installer. When the terminal block platform 220 is in the operational configuration, the one or more terminal blocks may be positioned or configured to receive one or more terminal pins of the EIM 202 within one or more apertures in the terminal blocks. It is contemplated that in the operational configuration, the terminal blocks may be oriented such that the terminal pins may be received within the terminal blocks when the EIM 202 is moved along a straight line path towards the wall that the wall mountable back plate 204 is mounted. When in the operational position, the terminal block platform 220 may cover at least a portion of the field wire receiving aperture 224. In some embodiments, the platform 220 may cover a majority (e.g. 50% or more) of the field wire receiving aperture 224. This is just an example. The terminal block platform 220 may cover 10% or more, 25% or more, 50% or more, 75% or more, 90% or more, or 100% of the field wire receiving aperture 224, as desired.

The terminal block platform 220 may be rotatably coupled to the housing 206 at a pair of hinges 226, or other rotation mechanism to move the terminal block platform 220 between the operational position and an open or installation position. The terminal block platform 220 may rotate away from the housing 206 such that the back side 246 of the terminal block platform 220 and/or a bottom surface of the terminal blocks are more accessible to an installer. For example, the bottom side 250 of the terminal block platform 220 may be configured to rotate away from the housing 206 and up towards the top edge 212 of the housing 206. This may facilitate a connection between the one or more field wires and the one or more terminal blocks. Further, rotation of the terminal block platform 220 way from the housing 206 may expose more of the field wire receiving aperture 224 relative to when the terminal block platform 220 is in the operational position. Rotatably coupling the terminal block platform 220 to the housing 206 may allow the installer to rotate the terminal blocks to a desired and/or comfortable position so the one or more field wires may be conveniently inserted into the terminal blocks. Additionally, rotation of the terminal block platform 220 may allow an installer to access one or more mounting apertures 236a, 236b, 236c which in some cases may be positioned behind the terminal block platform 220.

The hinges 226 may be positioned along the top edge 212 of the housing 206 at a point between the left edge 216 and the right edge 218. This is just an example, in some instances, the hinges 226 may be located along the left and/or right edge 216, 218 of the housing, as shown in Figures 4-9. The hinges 226 may be any mechanism that allows the terminal block platform 220 to rotate relative to the housing 206. In some embodiments, the hinges 226 may include a stop mechanism (not explicitly shown) configured to limit rotation of the platform 220. The stop mechanism may be configured to limit rotation of the terminal block platform 220 to 180° or less, 145° or less, 130° or less, 100° or less, 90° or less, etc.

Referring to Figure 13, the housing 206 may include a plurality of mounting apertures 236a, 236b 236c, collectively, 236). The mounting apertures 236 may be spaced from one another such that various combinations of the apertures 236 may be utilized to allow the housing 206 to be attached to a plurality of different junction boxes and/or wall configurations. For example, the mounting apertures 236 may be utilized in a similar manner to those described above with respect to Figures 6A-6F and 7A-7C. In some cases, one or more of the mounting apertures 236 may have an elongated shape to allow for more vertical and/or horizontal flexibility when aligning the mounting apertures 236 with a mating aperture in a junction box and/or mounting surface. When the terminal block platform 220 is in the operational position (shown in Figure 12), the platform 220 may cover at least some of the mounting apertures 236a, 236b 236c, although this is not required. In some embodiments, the terminal block platform 220 may be sized and shaped to cover a majority of the mounting apertures 236 (e.g. more than half) when in the operational position, and in some cases all of the mounting apertures 236. These are just examples. It is contemplated that the terminal block platform 220 may cover as many of or as few of the mounting apertures 236 as desired.

Generally, the housing 206 may have a generally square or rectangular shape. The housing 206 may include a mounting aperture positioned in or adjacent to each of the four corners of the housing 206 as shown. The wall mountable back plate 204 may include two or more mounting apertures 236a, 236b positioned on a first side of and adjacent to the intermediate region 238 of the field wire receiving aperture 224 and an additional mounting aperture 236c positioned on a second side and adjacent to the intermediate region 238 of the field wire receiving aperture 224. These are just examples. It is contemplated that the housing 206 may include more than three or fewer than three mounting apertures 236, as desired. It is further contemplated that the mounting apertures 236 may be arranged in configurations other than that described with respect to Figures 12 and 13.

While not explicitly shown, the terminal block platform 220 may include one or more releasable latches, or fastening mechanisms, for releasably securing the terminal block platform 220 to the housing 206, similar in form and function to the latches 142 described above. The latches may be configured to engage a mating latch structure on the housing 206. In some instances, the latches and mating latch structure may be disengaged from one another through the application of a pushing or pulling force on the latches. A first latch may be positioned along the left edge 216 of the housing 206 and a second latch may be positioned along the right edge 218 of the housing 206. This is just an example. The latches may be arranged in any configuration desired. Further, there may be more than two latches, or fewer than two latches, as desired.

It is further contemplated that the hinges and latches may be configured to space the terminal block platform 220 a distance from the wall or mounting surface. For example, the hinges and latches may extend a distance (e.g. away from front surface 228) beyond a back surface 246 of the terminal block platform 220 such that there is a gap between the wall and the back surface 246 of the terminal block platform 220. This may form a cavity or recess for the field wires which may help to minimize bending and/or kinking of the field wires. It is further contemplated that maintaining a space between the back surface 246 of the terminal block platform 220 and the mounting surface may help the field wires to enter the wall mountable back plate 204 via the field wire receiving aperture 224 (e.g. for a recessed wall box, hole in the wall, surface mounted wall box, etc.) or through one or more bottom openings (e.g. for a surface mounted wall box or surface mounted configuration, etc.) in the bottom edge 214 of the housing 206.

The housing 206 may further include one or more latch mechanisms 232 configured to releasably secure the EIM 202 to the wall mountable back plate 204. In some instances, the latch mechanisms 232 may be formed as a unitary structure with the hinges 226, although this is not required. The latch mechanisms 232 may be configured to cooperate with a mating latch mechanism on the EIM 202. In some instances, the EIM 202 may be removed from the wall mountable back plate 204 through a pulling and/or rotating motion. The housing 206 may further be provided with a fixation aperture (not explicitly shown in Figures 12-13). The fixation aperture may be configured to receive a screw, fastener, or other fixation mechanism configured to releasable secure the EIM 202 to the wall mountable back plate 204. It is contemplated that the fixation mechanism may help prevent the EIM 202 from being inadvertently detached from the wall mountable back plate 204 while still allowing for easy attachment and/removal of the EIM 202 to/from the wall mountable back plate 204. While the latch mechanisms 232 are illustrated along the top edge 212 of the housing, the latch mechanisms 232 may be positioned anywhere on the housing, including but not limited to the bottom edge 214, the left edge 216, the right edge 218, or within a central region.

### Additional Examples

In a first non-limiting example, a. wall mountable back plate for securing a Heating, Ventilation and/or Air Conditioning (HVAC) control module to a wall includes a housing having a front side and a back side, wherein the back side is configured to be mountable toward a wall. The housing defines a field wire receiving aperture through the back side of the housing, the field wire receiving aperture configured to accommodate one or more field wires. A terminal block platform is rotatably coupled to the housing, the terminal block platform including one or more terminal blocks that are configured to connect one or more field wires to one or more terminal pins of an HVAC control module.

Additionally, in another example, the terminal block platform may be configured to rotate between an operational position where the one or more terminal blocks are oriented to receive one or more terminal pins of an HVAC control module when an HVAC control module is moved along a straight line path toward the wall and an installation position wherein the one or more terminal blocks are rotated away from the wall such that a back side of the one or more terminal blocks is more accessible to an installer to facilitate a connection between the one or more field wires and the one or more terminal blocks.

Additionally, in another example, when in the operational position, the terminal block platform may be configured to overlap at least a majority of the field wire receiving aperture defined by the housing.

Additionally, in another example, when in the installation position, the terminal block platform may be configured rotate away from the housing to expose more of the field wire receiving aperture.

Additionally, in another example, the housing may further comprise a plurality of mounting apertures, the plurality of mounting apertures spaced to allow the housing to be secured to a plurality of different junction boxes.

Additionally, in another example, when in the operational position, the terminal block platform may be configured to overlap at least a majority of the mounting apertures of the housing.

Additionally, in another example, a bottom side of the terminal block platform may be configured to rotate away from the housing and up towards a top edge of the housing.

Additionally, in another example, the back plate may further comprise a stop mechanism configured to limit rotation of the terminal block platform.

Additionally, in another example, the back plate may further comprise one or more releasable latches for releasably latching the terminal block platform in the operational position.

Additionally, in another example, the housing may include one or more releasably latches for releasably securing an HVAC control module to the housing.

Additionally, in another example, the terminal block platform may be spaced a distance from the back side of the housing.

Additionally, in another example, the terminal block platform may be configured to rotate towards a top edge of the housing.

Additionally, in another example, the back plate may further comprise a first fastening mechanism positioned along a left edge of the front side of the housing and a second fastening mechanism positioned along a right edge of the front side of the housing, wherein the terminal block platform may be releasably coupled to the first and second fastening mechanisms such that when the terminal block platform is uncoupled with the first and second fastening mechanisms, the terminal block platform is rotatable relative to the housing.

Additionally, in another example, when the terminal block platform is coupled to the first and second fastening mechanisms, the terminal block platform is disposed over at least a portion the field wire receiving aperture.

Additionally, in another example, a first hinge may be positioned along a left edge of the front side of the housing and a second hinge may be positioned along a right edge of the front side of the housing, wherein the terminal block platform is rotatably coupled to the first and second hinges.

Additionally, in another example, the back plate may further comprise one or more latches disposed along an edge of the housing, the one or more latches configured to releasably secure a control module to the housing.

Additionally, in another example, the back plate may further comprise one or more visual markings disposed on the housing and/or raised platform, the one or more visual marking configured to facilitate wiring of the wall mountable back plate to or more field wires.

Additionally, in another example, the back plate may further comprise comprising a plurality of apertures disposed in the terminal block platform, the plurality of apertures configured to receive a plurality of terminal pins on a control module.

Additionally, in another example, the field wire receiving aperture may include a first portion and a second portion, the first portion have a width smaller than a width of the second portion.

Additionally, in another example, the plurality of mounting apertures may comprise a pair of mounting apertures positioned on either side of the first portion of the field wire receiving aperture.

Additionally, in another example, the plurality of mounting apertures may comprise a pair of mounting apertures positioned on either side of the second portion of the field wire receiving aperture.

Additionally, in another example, the housing may have a generally rectangular shape and the plurality of mounting apertures may comprise a mounting aperture positioned in each of a corner of the rectangular housing.

Additionally, in another example, a method for installing a wall mountable back plate to a wall may comprise securing a housing to the wall via a number of fasteners, the housing having a front side, a back side, a top side, a bottom side, a left side and a right side, wherein the back side is mountable toward the wall, rotating a terminal block platform relative to the housing from an operational position to an installation position, wherein in the operational position, the terminal block platform has one or more terminal blocks oriented to receive one or more terminal pins of an HVAC control module when an HVAC control module is moved along a straight line path toward the wall, and in the installation position, the one or more terminal blocks are rotated away from the wall such that a back side of the one or more terminal blocks is more accessible to an installer to facilitate a manual connection of one or more field wires to the one or more terminal blocks; with the terminal block platform in the installation position, manually connect one or more field wires to the one or more terminal blocks; and rotating the terminal block platform from the installation position to the operational position.

Additionally, in another example, the method may further comprise moving an HVAC control module along a straight line path towards the wall such that the one or more terminal blocks receive one or more terminal pins of the HVAC control module.

Additionally, in another example, the method may further comprise pulling the one or more field wires through a field wire receiving aperture in the housing to the one or more terminal blocks of the terminal block platform.

Additionally, in another example, the field wire receiving aperture may extend through the back side of the housing, and the terminal block platform covers at least a majority of the field wire receiving aperture when the terminal block platform is in the operational position.

Additionally, in another example, the field wire receiving aperture may extend through the bottom side of the housing, and wherein the one or more field wires are releasably clamped in position relative to the housing.

For the purposes of this document, a field wire is any wire and the term "field" is in a first instance merely an indication that it is a wire suitable for use in a HVAC system, such as described herein. In a second instance a field wire is an insulated electrically conductive wire for conducting power and/or electrical signals in a HVAC system. A field wire most preferably means wire already present "in the field", i.e. in situ where the back plate is to be installed. The wire may preferably be a pre-existing wire emerging from a surface, such as a wall, upon or over which the back plate is to be installed.

## Claims

1. A wall mountable back plate (104) for securing a Heating, Ventilation and/or Air Conditioning (HVAC) control module to a wall, the wall mountable back plate comprising:
a housing (106) having a front side (108) and a back side (110), wherein the back side is configured to be mountable toward a wall;
the housing defining a field wire receiving aperture (124) through the back side of the housing, the field wire receiving aperture configured to accommodate one or more field wires;
**characterized in that** the wall mountable back plate further comprises a terminal block platform (120) rotatably coupled to the housing, the terminal block platform including one or more terminal blocks (122) that are configured to connect one or more field wires to one or more terminal pins of an HVAC control module.

2. The wall mountable back plate of claim 1, wherein the terminal block platform is configured to rotate between:
an operational position where the one or more terminal blocks are oriented to receive one or more terminal pins of an HVAC control module when an HVAC control module is moved along a straight line path toward the wall; and
an installation position wherein the one or more terminal blocks are rotated away from the wall such that a back side of the one or more terminal blocks is more accessible to an installer to facilitate a connection between the one or more field wires and the one or more terminal blocks.

3. The wall mountable back plate of claim 2, wherein in the operational position, the terminal block platform is configured to overlap at least a majority of the field wire receiving aperture defined by the housing.

4. The wall mountable back plate of claim 3, wherein in the installation position, the terminal block platform is configured rotate away from the housing to expose more of the field wire receiving aperture.

5. The wall mountable back plate of claim 2, wherein the housing further comprises a plurality of mounting apertures (136), the plurality of mounting apertures spaced to allow the housing to be secured to a plurality of different junction boxes.

6. The wall mountable back plate of claim 5, wherein in the operational position, the terminal block platform is configured to overlap at least a majority of the mounting apertures of the housing.

7. The wall mountable back plate of any of claims 1-6, wherein a bottom side of the terminal block platform is configured to rotate away from the housing and up towards a top edge of the housing (112).

8. The wall mountable back plate of any of claims 1-7, further comprising a stop mechanism configured to limit rotation of the terminal block platform.

9. The wall mountable back plate of any of claims 2-6 further comprising one or more releasable latches (142) for releasably latching the terminal block platform in the operational position.

10. The wall mountable back plate of any one of claims 1-9, wherein the housing includes one or more releasably latches for releasably securing an HVAC control module to the housing.

11. A method for installing a wall mountable back plate (104), according to any of claims 1 to 10, to a wall, comprising:
securing the housing (106) to the wall via a number of fasteners, the housing having the front side (108), the back side (110), the top side (112), the bottom side (114), the left side (116) and the right side (118), wherein the back side is mountable toward the wall;
rotating the terminal block platform (120) relative to the housing from an operational position to an installation position, wherein in the operational position, the terminal block platform has one or more terminal blocks (122) oriented to receive one or more terminal pins of an HVAC control module when an HVAC control module is moved along a straight line path toward the wall, and in the installation position, the one or more terminal blocks are rotated away from the wall such that a back side of the one or more terminal blocks is more accessible to an installer to facilitate a manual connection of one or more field wires to the one or more terminal blocks;
with the terminal block platform in the installation position, manually connect one or more field wires to the one or more terminal blocks; and
rotating the terminal block platform from the installation position to the operational position.

12. The method of claim 11 further comprising moving an HVAC control module along a straight line path towards the wall such that the one or more terminal blocks receive one or more terminal pins of the HVAC control module.

13. The method of any of claims 11-12 further comprising pulling the one or more field wires through the field wire receiving aperture (124) in the housing to the one or more terminal blocks of the terminal block platform.

14. The method of claim 13, wherein the field wire receiving aperture extends through the back side of the housing, and the terminal block platform covers at least a majority of the field wire receiving aperture when the terminal block platform is in the operational position.

15. The method of claim 13, wherein the field wire receiving aperture extends through the bottom side of the housing, and wherein the one or more field wires are releasably clamped in position relative to the housing.

## Patentansprüche

1. Eine wandmontierbare Rückplatte (104) zum Befestigen eines Heizungs-, Lüftungsund/oder Klima-Steuermoduls (HLK-Steuermoduls) an einer Wand, wobei die wandmontierbare Rückplatte Folgendes beinhaltet:
ein Gehäuse (106) mit einer Vorderseite (108) und einer Rückseite (110), wobei die Rückseite dazu konfiguriert ist, in Richtung auf eine Wand montierbar zu sein;
wobei das Gehäuse eine Feldkabelaufnahmeöffnung (124) durch die Rückseite des Gehäuses definiert, wobei die Feldkabelaufnahmeöffnung dazu konfiguriert ist, ein oder mehrere Feldkabel unterzubringen;
**dadurch gekennzeichnet, dass** die wandmontierbare Rückplatte ferner eine Klemmenleistenplattform (120) beinhaltet, die drehbar an das Gehäuse gekoppelt ist, wobei die Klemmenleistenplattform eine oder mehrere Klemmenleisten (122) umfasst, die dazu konfiguriert sind, ein oder mehrere Feldkabel mit einem oder mehreren Anschlusspins eines HLK-Steuermoduls zu verbinden.

2. Wandmontierbare Rückplatte gemäß Anspruch 1, wobei die Klemmenleistenplattform dazu konfiguriert ist, sich zwischen Folgenden zu drehen:
einer Betriebsstellung, in der die eine oder die mehreren Klemmenleisten orientiert sind, um einen oder mehrere Anschlusspins eines HLK-Steuermoduls aufzunehmen, wenn ein HLK-Steuermodul entlang einer geradlinigen Bahn in Richtung auf die Wand bewegt wird; und
einer Installationsstellung, in der die eine oder die mehreren Klemmenleisten von der Wand weg gedreht sind, sodass eine Rückseite der einen oder der mehreren Klemmenleisten für einen Installateur zugänglicher ist, um eine Verbindung zwischen dem einen oder den mehreren Feldkabeln und der einen oder den mehreren Klemmenleisten zu erleichtern.

3. Wandmontierbare Rückplatte gemäß Anspruch 2, wobei in der Betriebsstellung die Klemmenleistenplattform dazu konfiguriert ist, mindestens einen Großteil der von dem Gehäuse definierten Feldkabelaufnahmeöffnung zu überlagern.

4. Wandmontierbare Rückplatte gemäß Anspruch 3, wobei in der Installationsstellung die Klemmenleistenplattform dazu konfiguriert ist, sich von dem Gehäuse weg zu drehen, um mehr der Feldkabelaufnahmeöffnung freizulegen.

5. Wandmontierbare Rückplatte gemäß Anspruch 2, wobei das Gehäuse ferner eine Vielzahl von Montageöffnungen (136) beinhaltet, wobei die Vielzahl von Montageöffnungen beabstandet sind, um zu ermöglichen, dass das Gehäuse an einer Vielzahl von verschiedenen Verteilerdosen befestigt wird.

6. Wandmontierbare Rückplatte gemäß Anspruch 5, wobei in der Betriebsstellung die Klemmenleistenplattform dazu konfiguriert ist, mindestens einen Großteil der Montageöffnungen des Gehäuses zu überlagern.

7. Wandmontierbare Rückplatte gemäß einem der Ansprüche 1-6, wobei eine Unterseite der Klemmenleistenplattform dazu konfiguriert ist, sich von dem Gehäuse weg und nach oben in Richtung auf eine Oberkante des Gehäuses (112) zu drehen.

8. Wandmontierbare Rückplatte gemäß einem der Ansprüche 1-7, ferner beinhaltend einen Anschlagmechanismus, der dazu konfiguriert ist, die Drehung der Klemmenleistenplattform zu beschränken.

9. Wandmontierbare Rückplatte gemäß einem der Ansprüche 2-6, ferner beinhaltend einen oder mehrere lösbare Riegel (142) zum lösbaren Verriegeln der Klemmenleistenplattform in der Betriebsstellung.

10. Wandmontierbare Rückplatte gemäß einem der Ansprüche 1-9, wobei das Gehäuse einen oder mehrere lösbare Riegel zum lösbaren Befestigen eines HLK-Steuermoduls an dem Gehäuse umfasst.

11. Ein Verfahren zum Installieren einer wandmontierbaren Rückplatte (104) gemäß einem der Ansprüche 1 bis 10 an einer Wand, das Folgendes beinhaltet:
Befestigen des Gehäuses (106) an der Wand mittels einer Anzahl von Befestigungselementen, wobei das Gehäuse die Vorderseite (108), die Rückseite (110), die Oberseite (112), die Unterseite (114), die linke Seite (116) und die rechte Seite (118) aufweist, wobei die Rückseite in Richtung auf die Wand montierbar ist;
Drehen der Klemmenleistenplattform (120) relativ zu dem Gehäuse aus einer Betriebsstellung in eine Installationsstellung, wobei in der Betriebsstellung die Klemmenleistenplattform eine oder mehrere zum Aufnehmen von einem oder mehreren Anschlusspins eines HLK-Steuermoduls, wenn das HLK-Steuermodul entlang einer geradlinigen Bahn in Richtung auf die Wand bewegt wird, orientierte Klemmenleisten (122) aufweist und in der Installationsstellung die eine oder die mehreren Klemmenleisten von der Wand weg gedreht sind, sodass eine Rückseite der einen oder der mehreren Klemmenleisten für einen Installateur zugänglicher ist, um eine manuelle Verbindung von einem oder mehreren Feldkabeln mit der einen oder den mehreren Klemmenleisten zu erleichtern;
mit der Klemmenleistenplattform in der Installationsstellung, manuelles Verbinden von einem oder mehreren Feldkabeln mit der einen oder den mehreren Klemmenleisten; und
Drehen der Klemmenleistenplattform aus der Installationsstellung in die Betriebsstellung.

12. Verfahren gemäß Anspruch 11, ferner beinhaltend das Bewegen eines HLK-Steuermoduls entlang einer geradlinigen Bahn in Richtung auf die Wand, sodass die eine oder die mehreren Klemmenleisten einen oder mehrere Anschlusspins des HLK-Steuermoduls aufnehmen.

13. Verfahren gemäß einem der Ansprüche 11-12, ferner beinhaltend das Ziehen des einen oder der mehreren Feldkabel durch die Feldkabelaufnahmeöffnung (124) in dem Gehäuse zu der einen oder den mehreren Klemmenleisten der Klemmenleistenplattform.

14. Verfahren gemäß Anspruch 13, wobei sich die Feldkabelaufnahmeöffnung durch die Rückseite des Gehäuses erstreckt und die Klemmenleistenplattform mindestens einen Großteil der Feldkabelaufnahmeöffnung abdeckt, wenn sich die Klemmenleistenplattform in der Betriebsstellung befindet.

15. Verfahren gemäß Anspruch 13, wobei sich die Feldkabelaufnahmeöffnung durch die Unterseite des Gehäuses erstreckt und wobei das eine oder die mehreren Feldkabel relativ zu dem Gehäuse lösbar in Position geklemmt sind.

## Revendications

1. Une plaque arrière montable au mur (104) pour fixer un module de commande de chauffage, de ventilation et/ou de climatisation (CVC) à un mur, la plaque arrière montable au mur comprenant :
un logement (106) ayant un côté avant (108) et un côté arrière (110), le côté arrière étant configuré pour être montable vers un mur ;
le logement définissant une ouverture de réception de fils in situ (124) à travers le côté arrière du logement, l'ouverture de réception de fils in situ étant configurée pour accueillir un ou plusieurs fils in situ ;
**caractérisée en ce que** la plaque arrière montable au mur comprend en outre une plate-forme à borniers (120) couplée de manière rotative au logement, la plate-forme à borniers incluant un ou plusieurs borniers (122) qui sont configurés pour connecter un ou plusieurs fils in situ à une ou plusieurs broches de borne d'un module de commande CVC.

2. La plaque arrière montable au mur de la revendication 1, où la plate-forme à borniers est configurée pour tourner entre :
une position opérationnelle dans laquelle les un ou plusieurs borniers sont orientés pour recevoir une ou plusieurs broches de borne d'un module de commande CVC lorsqu'un module de commande CVC est déplacé le long d'un trajet en ligne droite vers le mur ; et
une position d'installation dans laquelle les un ou plusieurs borniers sont tournés à l'opposé du mur de telle sorte qu'un côté arrière des un ou plusieurs borniers soit mieux accessible à un installateur afin de faciliter une connexion entre les un ou plusieurs fils in situ et les un ou plusieurs borniers.

3. La plaque arrière montable au mur de la revendication 2, où dans la position opérationnelle, la plate-forme à borniers est configurée pour chevaucher au moins une majorité de l'ouverture de réception de fils in situ définie par le logement.

4. La plaque arrière montable au mur de la revendication 3, où dans la position d'installation, la plate-forme à borniers est configurée pour tourner à l'opposé du logement afin d'exposer davantage de l'ouverture de réception de fils in situ.

5. La plaque arrière montable au mur de la revendication 2, où le logement comprend en outre une pluralité d'ouvertures de montage (136), la pluralité d'ouvertures de montage étant espacées afin de permettre au logement d'être fixé à une pluralité de différentes boîtes de jonction.

6. La plaque arrière montable au mur de la revendication 5, où dans la position opérationnelle, la plate-forme à borniers est configurée pour chevaucher au moins une majorité des ouvertures de montage du logement.

7. La plaque arrière montable au mur de n'importe lesquelles des revendications 1-6, où un côté inférieur de la plate-forme à borniers est configuré pour tourner à l'opposé du logement et vers le haut vers un bord supérieur du logement (112).

8. La plaque arrière montable au mur de n'importe quelles revendications 1-7, comprenant en outre un mécanisme d'arrêt configuré pour limiter la rotation de la plate-forme à borniers.

9. La plaque arrière montable au mur de n'importe lesquelles des revendications 2-6 comprenant en outre un ou plusieurs verrous libérables (142) pour verrouiller de manière libérable la plate-forme à borniers dans la position opérationnelle.

10. La plaque arrière montable au mur de l'une quelconque des revendications 1-9, où le logement inclut un ou plusieurs verrous libérables pour fixer de manière libérable un module de commande CVC au logement.

11. Un procédé d'installation d'une plaque arrière montable au mur (104), selon n'importe lesquelles des revendications 1 à 10, à un mur, comprenant :
la fixation du logement (106) au mur par l'intermédiaire d'un certain nombre de dispositifs de fixation, le logement ayant le côté avant (108), le côté arrière (110), le côté supérieur (112), le côté inférieur (114), le côté gauche (116) et le côté droit (118), où le côté arrière est montable vers le mur ;
la rotation de la plate-forme à borniers (120) relativement au logement depuis une position opérationnelle jusqu'à une position d'installation, où dans la position opérationnelle, la plate-forme à borniers présente un ou plusieurs borniers (122) orientés pour recevoir une ou plusieurs broches de borne d'un module de commande CVC lorsqu'un module de commande CVC est déplacé le long d'un trajet en ligne droite vers le mur, et dans la position d'installation, les un ou plusieurs borniers sont tournés à l'opposé du mur de telle sorte qu'un côté arrière des un ou plusieurs borniers soit mieux accessible à un installateur afin de faciliter une connexion manuelle d'un ou de plusieurs fils in situ aux un ou plusieurs borniers ;
la plate-forme à borniers étant dans la position d'installation, la connexion manuelle d'un ou de plusieurs fils in situ aux un ou plusieurs borniers ; et
la rotation de la plate-forme à borniers depuis la position d'installation jusqu'à la position opérationnelle.

12. Le procédé de la revendication 11 comprenant en outre le déplacement du module de commande CVC le long d'un trajet en ligne droite vers le mur de telle sorte que les un ou plusieurs borniers reçoivent une ou plusieurs broches de borne du module de commande CVC.

13. Le procédé de n'importe quelles revendications 11-12 comprenant en outre le tirage des un ou plusieurs fils in situ à travers l'ouverture de réception de fils in situ (124) dans le logement jusqu'aux un ou plusieurs borniers de la plate-forme à borniers.

14. Le procédé de la revendication 13, où l'ouverture de réception de fils in situ s'étend à travers le côté arrière du logement, et la plate-forme à borniers couvre au moins une majorité de l'ouverture de réception de fils in situ lorsque la plate-forme à borniers est dans la position opérationnelle.

15. Le procédé de la revendication 13, où l'ouverture de réception de fils in situ s'étend à travers le côté inférieur du logement, et où les un ou plusieurs fils in situ sont serrés en position de manière libérable relativement au logement.
